# EUROPÄISCHE PATENTSCHRIFT

(11) **EP 0 898 368 B1**
(45) Veröffentlichungstag und Bekanntmachung des Hinweises auf die Patenterteilung: **12.11.2003**
(21) Anmeldenummer: 98115296.0
(22) Anmeldetag: 13.08.1998
(51) Int. Cl.: H03K 17/945, G01B 7/02

(54) **Sensoreinrichtung**
Sensor device
Dispositif capteur

(30) Priorität: 20.08.1997 DE 19736258; 11.09.1997 DE 19740017
(43) Veröffentlichungstag der Anmeldung: 24.02.1999
(73) Patentinhaber: Nord-Micro AG & Co. OHG, 60388 Frankfurt am Main (DE)
(72) Erfinder: Weimer, Georg, 85229 Kleinschwabhausen (DE); Sütsch, Peter, Dr., 85253 Erdweg (DE)
(74) Vertreter: Preissner, Nicolaus, Dipl.-Ing.

(56) Entgegenhaltungen:
- US-A- 4 866 377
- US-A- 5 410 488

## Beschreibung

Die Erfindung betrifft eine Sensoreinrichtung zum berührungslosen Überwachen einer definierten Endposition eines mechanischen Funktionsteils, insbesondere einer Tür in einem Flugzeug. Die Sensoreinrichtung umfaßt einen an einem Flugzeug befestigten Fühler zum Abtasten einer Entfernung zwischen dem Fühler und einer Meßfläche an einem Funktionsteil, eine elektronische Meßschaltung, die mit dem Fühler verbunden und derart ausgebildet ist, daß auf mindestens ein Steuersignal hin ein der Entfernung entsprechendes Meßsignal erzeugt wird, und eine Steuerschaltung, die mit der elektronischen Meßschaltung über Leitungen verbunden ist, das Steuersignal erzeugt, das Meßsignal empfängt und ein Anzeigesignal zum Anzeigen der festgestellten Endposition erzeugt.

Bei der Überwachung der Funktionsfähigkeit von mechanischen Funktionsteilen in Flugzeugen kommt es darauf an, daß sowohl vor einem Start als auch während des Fluges exakte und verläßliche Daten zur Verfügung stehen. Beispielsweise ist es von allergrößter Wichtigkeit, daß das Personal über den Schließzustand der Türen informiert wird. Besonders problematisch sind hierbei Frachtraumtüren, da sowohl deren Größe als auch rauhe Behandlung beim Be- und Entladen zu Störungen führen können. Auch der "normale" Verschleiß sowie bleibende (langsame) Materialverformungen können zu ungenauem und ungenügendem Schließen führen. Aus diesem Grund werden zum einen Sensoreinrichtungen der eingangs genannten Art eingebaut, zum anderen werden diese im Rahmen von Wartungsarbeiten immer wieder überprüft.

Die US 5,410,488 offenbart eine Vorrichtung zum Testen der Funktionsfähigkeit eines Nährungssensors und zum präzisen Messen eines Spalts zwischen dem Nährungssensor und dessen Ziel. Zu diesem Zweck wird der Nährungssensor mit einem Signal bekannter Frequenz angeregt und die Impedanz des Nährungssensors gemessen. Der gemessene Wert wird mittels einer Referenztabelle in eine Spaltbreite umgewandet, die mit Sollwerten für den zu testenden Nährungssensor verglichen wird. Eine Abweichung der gemessenen Spaltbreite von dem vorgegebenen Sollwert wird als Spaltfehler festgehalten.

Die bisher bekannten Sensoreinrichtungen sind nur bedingt tauglich, den Schließzustand der Türen, ganz allgemein aber die Endposition eines mechanischen Funktionsteils mit einer so großen Zuverlässigkeit und Genauigkeit zu überprüfen, daß die Wartungsarbeiten erleichtert und die Flugsicherheit erhöht werden.

Der Erfindung liegt die **Aufgabe** zugrunde, eine Sensoreinrichtung zu schaffen, durch welche die Flugsicherheit bei geringem Aufwand bezüglich Konstruktion und Wartung erhöht wird.

Diese Aufgabe wird durch eine Sensoreinrichtung nach dem Patentanspruch 1 **gelöst**.

Ein wesentlicher Aspekt der so ausgebildeten Erfindung liegt darin, daß das Meßsignal in Antwort auf ein Steuersignal erzeugt wird, das in der entfernt von der Meßschaltung mit Fühler anzuordnenden Steuerschaltung erzeugt wird. Dadurch ist es möglich, die Funktionsfähigkeit des Gesamtsystems einfach zu prüfen. Die Steuerschaltung ist dabei zur Erzeugung einer Gruppe von Steuersignalen ausgebildet, und die Meßschaltung ist derart ausgebildet, daß bei Empfang eines jeden Steuersignals aus einer Gruppe von Steuersignalen ein anderer Vergleichswert erzeugt wird, der mit einem von der Entfernung abhängigen Signal des Fühlers verglichen wird. Die Meßschaltung ist so ausgebildet, daß sie bei Übereinstimmung eines Vergleichswerts mit dem Signal des Fühlers das Meßsignal vorzugsweise als digitales Signal erzeugt. Die Steuerschaltung wiederum ist derart ausgebildet, daß das Anzeigesignal aus einem Vergleich der zeitlichen Übereinstimmung des Steuersignals mit dem Meßsignal gebildet wird. Dieses System hat den Vorteil, daß im Steuersystem alle Daten vorliegen, die Auskunft darüber geben, was momentan im Meßsystem abläuft. Die "Antworten" des Meßsystems sind also für das Steuersystem leicht "verständlich". Die Störungssicherheit ist gegenüber einem freilaufenden Meßsystem erheblich größer.

Vorzugsweise ist die elektronische Meßschaltung am Fühler angeordnet, besonders vorzugsweise mit diesem in einer baulichen Einheit zusammengefaßt. Durch diese räumliche Nähe ist es möglich, Störungen zwischen Fühler und Meßschaltung praktisch vollständig zu eliminieren und die Meßschaltung besonders massiv und gegen mechanische Beanspruchung unanfällig auszubilden.

Vorzugsweise sind die elektronische Meßschaltung und die Steuerschaltung derart ausgebildet, daß das Steuersignal, das Meßsignal und eine Stromversorgung für die Meßschaltung über lediglich zwei Leitungen zwischen Meßschaltung und Steuerschaltung übertragen werden. Dies bringt eine weitere Vereinfachung des Ein- und Ausbaus der Anordnung sowie eine erhöhte Störungssicherheit mit sich.

Vorzugsweise ist die Meßschaltung derart ausgebildet, daß das Meßsignal von der elektronischen Meßschaltung in einem zeitlichen Abstand nach Empfang des mindestens einen Steuersignals erzeugt wird. Dadurch kann eine Vielzahl von Meßschaltungen mit Sensoren von einer einzigen Steuereinheit abgefragt werden.

Vorzugsweise umfaßt die elektronische Meßschaltung eine Kodiereinrichtung, die in Übereinstimmung mit empfangenen Steuersignalen Vergleichswerte erzeugt, eine Vergleichsschaltung, welche die Vergleichswerte mit der Entfernung entsprechenden Signalen des Fühlers vergleicht und das Meßsignal dann erzeugt, wenn der erzeugte Vergleichswert mit dem Signal des Fühlers im wesentlichen übereinstimmt. Durch diese Ausführungsform wird die Beziehung zwischen den "anfragenden" Signalen und den "Antworten" der Meßschaltung besonders klar und einfach. Gleiches gilt für den Aufbau der Gesamtanordnung. Diese umfasst in diesem Fall vorzugsweise als Kodiereinrichtung einen (Binär-)Zähler, während die Steuerschaltung einen Taktgenerator umfaßt, der Steuersignale als Zählbeziehungsweise Clocksignale für den Zähler erzeugt. Weiterhin erzeugt die Steuerschaltung ein Rücksetzsignal, das nach einer Gruppe von Zählbeziehungsweise Clocksignalen abgegeben wird, deren Anzahl dem zu einem maximalen Vergleichswert gehörigen Inhalt des Zählers gehört und den Zähler dann in einen Anfangszustand (Inhalt "0") zurücksetzt. Der Vergleichswert entspricht dem Zählerinhalt, kann zum Beispiel mit steigendem Zählerinhalt steigen und wird über einen D/A-Wandler, zum Beispiel ein schaltbares Widerstandsnetzwerk, erzeugt. Diese Ausführungsform ist besonders einfach und mit auf dem Markt erhältlichen Bauteilen leicht realisierbar. Beim Aufwärtszählen wird das Meßsignal dann erzeugt, wenn der (steigende) Vergleichswert das der Entfernung entsprechende Signal des Fühlers überschreitet.

Die Steuerschaltung weist vorzugsweise eine Überwachungseinrichtung zur Überwachung der Funktionsfähigkeit der Meßschaltung samt dem Fühler auf. Diese wiederum umfaßt vorzugsweise eine Strommeßeinrichtung zur Überwachung eines Versorgungsstroms für die Meßschaltung mit Fühler und zwar insbesondere in einem besonderen Funktionszustand, also nicht (nur) im Ruhezustand. Insbesondere wird dann die Funktion der Meßschaltung samt Fühler als gestört angenommen, wenn plötzlich keine Meßsignale trotz Erzeugung von Zähl- bzw. Clocksignalen erzeugt werden.

Bei einer bevorzugten Ausführungsform der Erfindung umfaßt der Fühler einen Schwingkreis mit einer Spule. Die Güte des Schwingkreises wird hierbei durch die räumliche Beziehung der Spule zur Meßfläche verändert. Hierbei kann sowohl die Güte des Schwingkreises als auch (gegebenenfalls zusätzlich) dessen Resonanzfrequenz verändert werden.

Bevorzugte Ausführungsformen der Erfindung ergeben sich aus den Unteransprüchen.

Nachfolgend wird die Erfindung anhand von Ausführungsbeispielen erläutert, zu deren Verständnis die beiliegenden Abbildungen dienen. Hierbei zeigen:
- Fig. 1: ein Blockschaltbild einer Ausführungsform der Erfindung,
- Fig. 2: eine ausführbare Schaltung der Ausführungsform der Erfindung nach Fig. 1 und
- Fig. 3: ein Zeitdiagramm zur Erläuterung von Schaltzuständen wichtiger Einzelteile des Aufbaus nach den Fig. 1 und 2.

Bei der nachfolgenden Erläuterung werden für gleiche und gleichwirkende Teile dieselben Bezugsziffern verwendet.

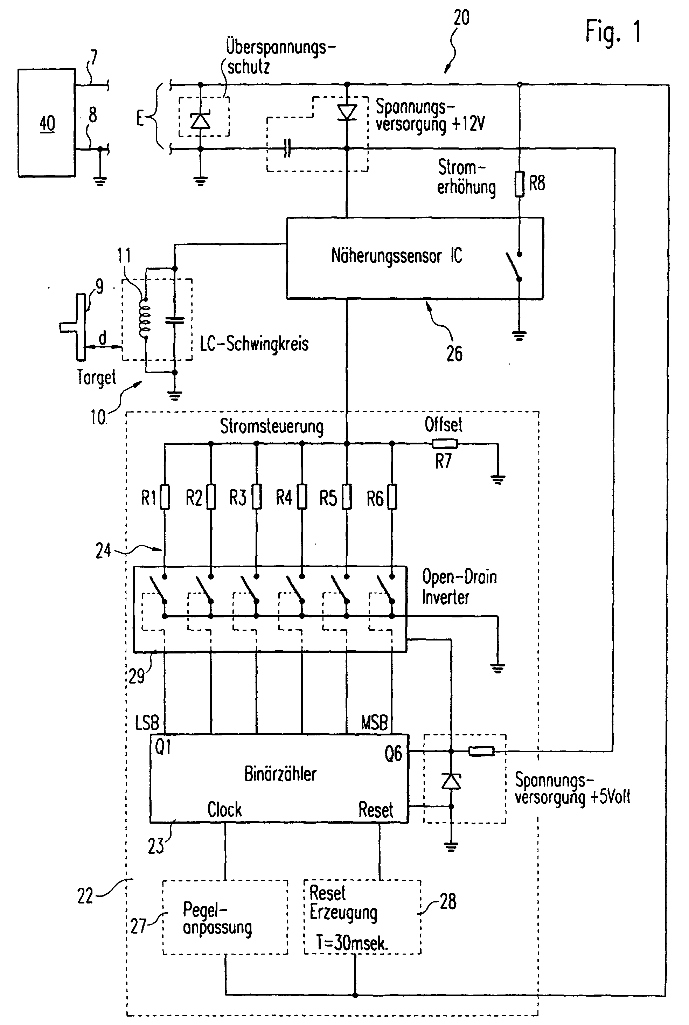

In Fig. 1 ist mit der Bezugsziffer 40 eine Steuerschaltung gezeigt, die über Leitungen 7 und 8 (Masse) mit einer Meßschaltung (20) verbunden ist.

Die Meßschaltung (20) weist an ihrem Eingang E eine Transsorberdiode auf, die zwischen die erste Leitung 7 und die zweite Leitung 8 zur Begrenzung der zwischen den Leitungen 7 und 8 stehenden Spannungen auf einen für die Bauteile ungefährlichen Wert im wesentlichen knapp über der Versorgungsspannung (vorzugsweise + 12V) eingestellt ist.

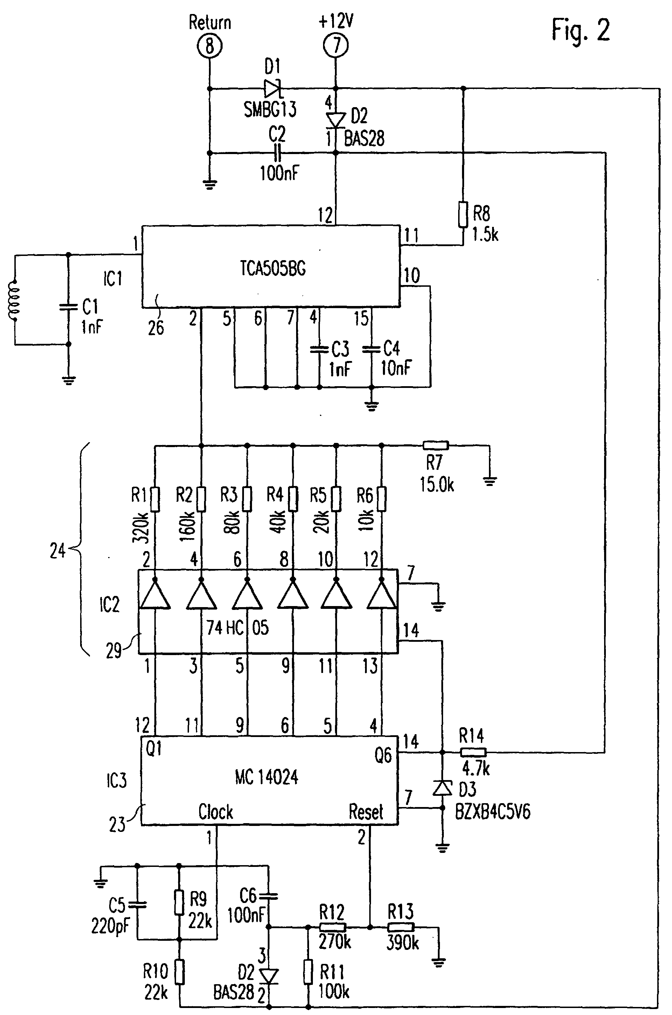

Ein Näherungssensor-IC 26, das beim Ausführungsbeispiel nach Fig. 2 als handelsüblicher Baustein TCA 505 BG ausgeführt ist, weist einen Versorgungsspannungseingang (PIN 12 in Fig. 2) auf, der mit dem Ausgang einer Gleichrichterschaltung bestehend aus einer in Durchlaßrichtung geschalteten Diode (D2 in Fig. 2) und einem Glättungskondensator (C2 in Fig. 2) verbunden ist. Ein Ausgang (PIN 11 in Fig. 2) ist über einen Widerstand (R8 in Fig. 2) mit der Leitung 7 verbunden. Ein Eingang (PIN 1 in Fig. 2) ist mit einem Fühler 10 verbunden, der eine Spule 11 mit dazu parallelgeschaltetem Kondensator (C1 in Fig. 2) umfaßt. Der so gebildete LC-Schwingkreis kann in seiner Güte (und in geringem Maß in seiner Resonanzfrequenz) verändert werden, indem man eine Meßfläche 9 in ihrem Abstand zur Spule 11 verändert. Eine derartige Anordnung ist an sich bekannt.

Weiterhin umfaßt die Meßschaltung 20 eine Kodiereinrichtung 22, die im wesentlichen aus einem Binärzähler 23 und einem schaltbaren Widerstandsnetzwerk 24 besteht, das als D/A-Wandler verstanden werden kann.

Der Binärzähler 23, der gemäß Fig. 2 einen Baustein MC 14024 umfassen kann, weist einen Clock-Eingang (PIN 1 in Fig. 2) auf, der über eine Pegelanpassung 27 mit der Leitung 7 verbunden ist. Die Pegelanpassung 27 umfaßt - wie in Fig. 2 gezeigt - eine Spannungsteilerschaltung bestehend aus den Widerständen R 9 und R 10, welche die Spannung auf der Leitung 7 (gegenüber Masse) halbiert. Weiterhin ist ein Filter-Kondensator C 5 zwischen Clock und Masse geschaltet, der Störungen in Form von Nadelimpulsen kurzschließt.

Ein Reset-Eingang (PIN 2 in Fig. 2) des Binärzählers 23 ist über eine Reset-Erzeugung 28 ebenfalls an die Leitung 7 angeschlossen, wie dies in Fig. 1 gezeigt ist. Diese Reset-Erzeugung 28 umfaßt - wie in Fig. 2 gezeigt - ebenfalls eine Spannungsteilerschaltung, bestehend aus einer Reihenschaltung von drei Widerständen. Hierbei sind die drei Widerstände R 11, R 12 und R 13 zwischen die Leitung 7 und Masse geschaltet. Zwischen dem Reset-Eingang des Binärzählers 23 und Masse liegt der Widerstand R 13. Der mit der Leitung 7 verbundene Widerstand R 11 ist von einer Diode D 2 (in Sperrichtung) überbrückt. Der Verbindungspunkt zwischen der Diode D 2, dem Widerstand R 11 und dem Widerstand R 12 ist über einen Filterkondensator C 6 mit Masse verbunden. Durch dieses Netzwerk ist eine (unsymmetrische) Tiefpaßschaltung gebildet, deren Zeitkonstante etwa bei 30 msek (für Pulse ansteigender Polarität, bei denen die Diode D 2 sperrt) liegt.

Weiterhin sind ein Masse-Eingang des Binärzählers 23 (PIN 7 in Fig. 2) und ein Stromversorgungseingang (PIN 14 in Fig. 2) über eine Zenerdiode zur Stabilisierung der Versorungsspannung und einen Widerstand (R 14 in Fig. 2) mit dem Stromversorgungseingang (PIN 12 in Fig. 2) des Näherungssensors 26 verbunden.

Der Binärzähler 23 weist 6 Ausgänge (Q1=LSB; Q6=MSB) auf, welche auf einen Schalter-Baustein (29) geführt sind, der in Fig. 2 vom Typ 74 HC 05 ausgebildet ist. Eine Stromversorgung des Schalterbausteins (29) ist mit der Stromversorgung des Binärzählers 23 verbunden. Die Ausgänge des Binärzählers 23 steuern die Schaltzustände des Schalterbauteils 29 derart, daß Ausgänge (PINs 2, 4, 6, 8, 10 und 12 in Fig. 2) des Schalterbausteins 29 entsprechend den Signalen aus dem Binärzähler 23 auf Masse gelegt oder offengehalten werden.

Die Ausgänge des Schalterbausteins 29 sind über Widerstände R1 bis R 6 auf einen Vergleichseingang (PIN 2 in Fig. 2) des Näherungssensors 26 geführt, der darüber hinaus über einen weiteren Widerstand R 7 auf Masse liegt. Auf diese Weise bilden die Widerstände R 1 bis R 7 ein durch den Schalter-Baustein 29 schaltbares Widerstandsnetzwerk.

Ein Ausgang (PIN 11 in Fig. 2) des als Vergleicherschaltung 26 wirkenden Näherungssensor IC ist über einen Widerstand R 8 mit der Leitung 7 verbunden.

Die Vergleicherschaltung 26 ist nun derart ausgebildet, daß aus der Güte des LC-Schwingkreises des Fühlers 10 ein der Entfernung d der Spule 11 zur Meßfläche 9 entsprechendes Signal gebildet wird, das mit einem Vergleichssignal verglichen wird, welches einem Strom entspricht, der über das Widerstandsnetzwerk 24 bzw. die Widerstände R1 - R7 und den Schalterbaustein 29 zu Masse fließt. Dann, wenn das Signal des Fühlers und der Vergleichswert übereinstimmen, wird ein Schalter geschlossen, der den Widerstand R 8 auf Masse legt, so daß durch die Leitung 7 aus der Steuerschaltung 40 ein erhöhter Strom fließt.

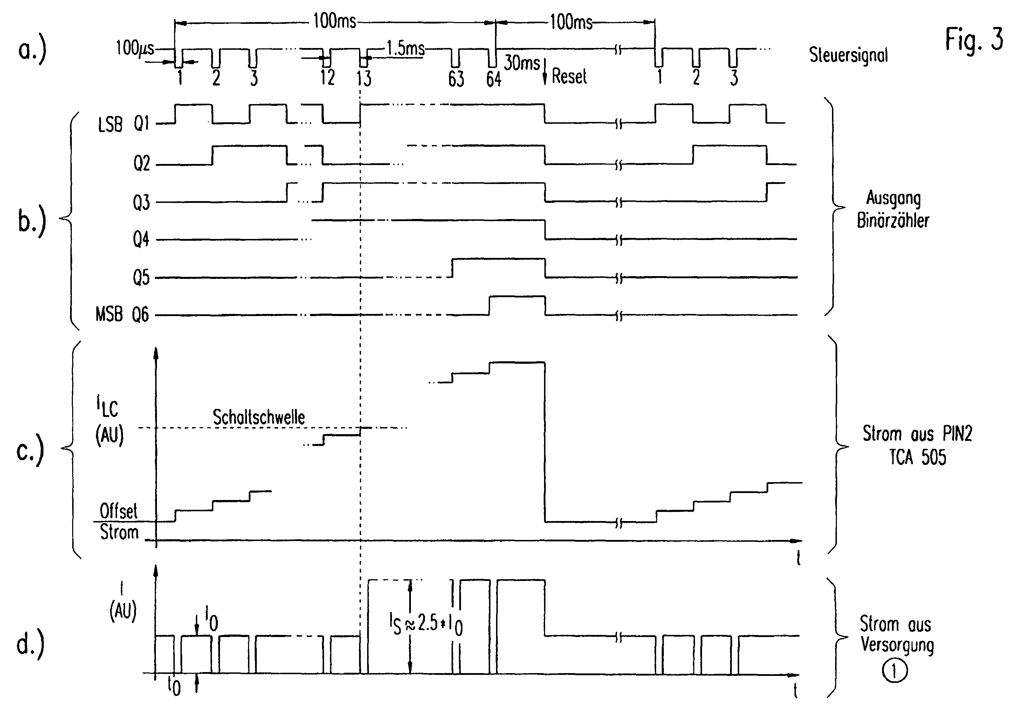

Nachfolgend wird der Betrieb der hier gezeigten Ausführungsformen der Erfindung anhand von Fig. 3 näher erläutert.

Im obersten Diagramm a.) aus Fig. 3 ist der Verlauf eines Steuersignals über die Zeit (isoliert) aufgezeichnet, das der Versorgungsspannung auf der Leitung 7 durch entsprechende Schaltungseinrichtungen in der Steuerschaltung 40 aufgeprägt ist.

Mit b.) sind Schaltzustände am Ausgang des Zählers 23 bezeichnet.

Der Vergleichswert an der Vergleicherschaltung 26 ist in Fig. 3 im Diagramm c.) als Stromwert angegeben, wobei mit dem Wort "Schaltschwelle" derjenige Vergleichswert bezeichnet ist, der dem Signal aus dem Fühler 10 entspricht.

Im Diagramm d.) der Fig. 3 ist die Höhe des Stroms über die Zeit schematisiert wiedergegeben, der durch die Leitung 7 fließt.

Zum Zeitpunkt t₀ beginnt ein in der Steuerschaltung 40 vorgesehener Taktgenerator Impulse mit einer Dauer von etwa 100µs abzugeben, welche den Strom aus der Steuerschaltung 40 kurzzeitig kräftig absinken lassen. Diese Taktimpulse gelangen zum Clock-Eingang des Zählers 23, so daß dieser seinen Inhalt erhöht, wodurch wiederum der Strom aus dem PIN 2 der Vergleicherschaltung 26 steigt. Dies ist in Fig. 3 bis zum dreizehnten Impuls gezeigt, bei welchem - der Annahme in diesem Beispiel entsprechend - der Vergleichswert (PIN 2 der Vergleicherschaltung 26) das Signal (entsprechend der "Schaltschwelle" in Fig. 3c.) aus dem Sensor 10 überschreitet.

Sobald dieser Vergleichswert mindestens erreicht ist, wird der Widerstand R 8 mit Masse verbunden, so daß nicht mehr nur ein Versorgungsstrom (in Fig. 3 mit I₀ bezeichnet) fließt, sondern ein erhöhter Strom I_{S}, der vorzugsweise etwa das 2,5fache des "normalen" Versorgungsstroms I₀ beträgt. Dieser erhöhte Strom I_{S} kann nun in der Steuerschaltung 40 festgestellt werden. Aus dieser Übereinstimmung der Stromerhöhung, die als Meßsignal zur Verfügung steht, mit dem dreizehnten, als Steuersignal wirkenden Taktimpuls, wird nun in der Steuerschaltung 40 ein Anzeigesignal gebildet, welches die Entfernung d zwischen dem Fühler 10 und der Meßfläche 9 wiedergibt.

Das Meßsignal (der überhöhte Strom I_{S}) fließt nun so lange, bis nicht nur das 64. Steuersignal (Taktimpuls) den Zähler 23 zu Ende gezählt hat, sondern auch noch über eine gewisse Zeitdauer hinaus, welche durch die Zeitkonstante der Reset-Erzeugung 28 bestimmt wird. Nach dem 64. Steuersignal (bei größeren Zählern 23 entsprechend mehr Steuersignale) sendet nämlich die Steuerschaltung 40 keine Steuersignale mehr während eines Zeitraums von ca. 100ms. Durch die Zeitkonstante (30ms) der Reset-Erzeugung 28 ist nun gewährleistet, daß nach eben diesem Zeitintervall von etwa 30ms die Spannung am Reset-Eingang (PIN 2 in Fig. 2) des Zählers 23 auf einen wirksamen Wert ansteigt, so daß der Zähler 23 zurückgesetzt wird. Dieser Zeitpunkt ist in Fig. 3 mit RESET bezeichnet.

Nach Ablauf der Pause (bei diesem Ausführungsbeispiel 100ms) beginnt die Steuerschaltung 40 erneut Steuersignale zu senden, so daß der Zählvorgang bzw. der Meßvorgang erneut beginnt.

Die Steuerschaltung 40 ist weiterhin so ausgebildet, daß aus der Höhe des Versorgungsstroms I (entsprechend d.) aus Fig. 3) die Funktionsfähigkeit bzw. eine Störung der Meßschaltung samt Fühler herleitbar ist.

Aus obigem geht hervor, daß man mit der hier gezeigten Ausführungsform der Erfindung nicht nur feststellen kann, ob der Abstand d zwischen dem Fühler 10 und der Meßfläche 9 hinreichend gering ist, so daß man ein vollständiges Schließen der Tür (welche die Meßfläche 9 trägt) feststellen kann, sondern auch, wie groß dieser Abstand tatsächlich ist. Daraus wiederum ist es möglich, bei der Wartung Erkenntnisse über den Zustand des Schließ- und Aufhängemechanismus der Tür zu gewinnen. Das System ist außerordentlich leicht auch vor Einbau in ein Flugzeug zu eichen bzw. zu kalibrieren, so daß man das Meßsystem selbst verwenden kann, um den Einbau der Meßfläche 9 und deren Grund-Position zum Fühler 10 zu bestimmen. Die Tatsache, daß sämtliche Signale über lediglich zwei Leitungen zwischen der Steuereinheit 40 und der Meßschaltung 20 fließen, führt dazu, daß ein äußerst einfach zu installierendes und störungsunanfälliges System zur Verfügung steht. Die in der Meßschaltung 20 eingebaute Elektronik ist sozusagen passiv und arbeitet ausschließlich auf die Steuersignale hin, welche von der Steuerschaltung 40 ausgesandt werden. Dadurch ist eine weitere Absenkung der Störanfälligkeit möglich. Weiterhin können dadurch derart vorkalibrierte Meßschaltungen mit Fühler zur Verfügung gestellt werden, daß deren Austauschbarkeit ganz erheblich erleichtert wird. Es ist sozusagen keine Anpassung zwischen der Meßschaltung mit Fühler und der Steuerschaltung notwendig.

### Bezugzeichenliste

- E: Eingang
- d: Entfernung
- 7: erste Leitung
- 8: zweite Leitung (Masse)
- 9: Meßfläche
- 10: Fühler
- 11: Spule
- 20: Meßschaltung
- 22: Kodiereinrichtung
- 23: Binärzähler
- 24: Widerstandsnetzwerk
- 26: Vergleicherschaltung
- 27: Pegelanpassung
- 28: Reset-Erzeugung
- 29: Schalterbaustein
- 40: Steuerschaltung

## Patentansprüche

1. Sensoreinrichtung zum berührungslosen Überwachen einer definierten Position, insbesondere Endposition, eines mechanischen Funktionsteils, insbesondere einer Tür in einem Flugzeug, umfassend
einen an einem Flugzeug befestigten Fühler (10) zum Abtasten einer Entfernung (d) zwischen dem Fühler (10) und einer Meßfläche (9) an einem Funktionsteil;
eine elektronische Meßschaltung (20), die mit dem Fühler (10) verbunden und derart ausgebildet ist, daß auf mindestens ein Steuersignal hin ein der Entfernung (d) entsprechendes Meßsignal erzeugt wird, und
eine Steuerschaltung (40), die mit der elektronischen Meßschaltung (20) über Leitungen (7, 8) verbunden ist, das Steuersignal erzeugt, das Meßsignal empfängt und ein Anzeigesignal zum Anzeigen der festgestellten Endposition erzeugt, **dadurch gekennzeichnet, daß** die Steuerschaltung (40) zur Erzeugung einer Gruppe von Steuersignalen und die elektronische Meßschaltung (20) derart ausgebildet sind, daß beim Empfang eines jeden Steuersignals aus der Gruppe von Steuersignalen ein anderer Vergleichswert erzeugt wird, der mit einem von der Entfernung (d) abhängigen Signal des Fühlers (10) verglichen wird, wobei die elektronische Meßschaltung (20) bei einer Übereinstimmung eines Vergleichswerts mit dem Signal des Fühlers (10) das Meßsignal erzeugt und wobei die Steuerschaltung (40) derart ausgebildet ist, daß das Anzeigesignal aus einem Vergleich der zeitlichen Übereinstimmung des Steuersignals mit dem Meßsignal gebildet wird.

2. Sensoreinrichtung nach Anspruch 1, **dadurch gekennzeichnet, daß** die elektronische Meßschaltung (20) am Fühler (10) vorzugsweise mit diesem eine bauliche Einheit, insbesondere Gehäuse Einheit, bildend angeordnet ist.

3. Sensoreinrichtung nach Anspruch 1 oder 2, **dadurch gekennzeichnet, daß** die elektronische Meßschaltung (20) und die Steuerschaltung (40) derart ausgebildet sind, daß das Steuersignal, das Meßsignal und eine Stromversorgung für die elektronische Meßschaltung (20) über lediglich zwei Leitungen (7, 8) zwischen der elektronischen Meßschaltung (20) und der Steuerschaltung (40) übertragen werden.

4. Sensoreinrichtung nach einem der Ansprüche 1 bis 3, **dadurch gekennzeichnet, daß** die elektronische Meßschaltung (20) derart ausgebildet ist, daß das Meßsignal von der elektronischen Meßschaltung (20) in einem zeitlichen Abstand nach Empfang des mindestens einen Steuersignals erzeugt wird.

5. Sensoreinrichtung nach einem der Ansprüche 1 bis 4, **dadurch gekennzeichnet, daß** die elektronische Meßschaltung (20) eine Kodiereinrichtung (22), die in Übereinstimmung mit empfangenen Steuersignalen Vergleichswerte erzeugt, und eine Vergleicherschaltung (26) aufweist, welche die Vergleichswerte mit die Entfernung (d) repräsentierenden Signalen des Fühlers (10) vergleicht und das Meßsignal dann erzeugt, wenn der erzeugte Vergleichswert mit dem Signal des Fühlers (10) übereinstimmt.

6. Sensoreinrichtung nach Anspruch 5, **dadurch gekennzeichnet, daß** die Kodiereinrichtung (22) einen Binär-Zähler (23) umfaßt, der den einem Zählerinhalt entsprechenden, insbesondere mit steigendem Zählerinhalt steigenden Vergleichswert über einen angeschlossenen D/A-Wandler, insbesondere über ein schaltbares Widerstandsnetzwerk (24) erzeugt, daß die Steuerschaltung (40) einen Taktgenerator umfaßt, der Steuersignale als Zähl- beziehungsweise Clocksignale für den Zähler (23) sowie ein Rücksetzsignal erzeugt, das nach einer Gruppe von Zähl- beziehungsweise Clocksignalen deren Anzahl den zu einem maximalen Vergleichswert gehörigen Inhalt des Zählers (23) gehört, den Zähler (23) in einen Anfangszustand (0) zurückversetzt.

7. Sensoreinrichtung nach einem der Ansprüche 1 bis 6, **dadurch gekennzeichnet, daß** die Steuereinrichtung (40) eine Überwachungseinrichtung zur Überwachung der Funktionsfähigkeit der elektronischen Meßschaltung (20) mit Fühler (10) umfaßt, die vorzugsweise eine Strommeßeinrichtung zur Überwachung eines Versorgungsstroms für die elektronische Meßschaltung (20) mit Fühler (10) umfaßt.

8. Sensoreinrichtung nach einem der Ansprüche 1 bis 7, **dadurch gekennzeichnet, daß** der Fühler (10) einen Schwingkreis mit einer Spule (11) umfaßt, wobei eine Güte des Schwingkreises (10) durch eine räumliche Beziehung der Spule (11) zur Meßfläche (9) veränderbar ist.

## Claims

1. A sensor device for use in proximity monitoring a defined position, more particularly end position, of a mechanical function part, more particularly a door in an aircraft comprising
a probe (10) attached to an aircraft for sensing a distance (d) between said probe (10) and a target surface (9) on said mechanical function part;
an electronic measuring circuit (20) connected to said probe (10) and so configured that in response to at least one control signal it generates a measurement signal corresponding to said distance (d), and
a control circuit (40) connected via leads (7, 8) to said electronic measuring circuit (20) and operable to generate said control signal, to receive said measurement signal and to generate an indicator signal to indicate that said defined end position has been detected, **characterized in that** said control circuit (40) is configured to produce a string of control signals, and said electronic measuring circuit (20) is configured such that on receiving each control signal in said string thereof a different reference value is generated which is compared to a signal of said probe (10) as a function of said distance (d), said electronic measuring circuit (20) generating said measurement signal when a reference value agrees with the signal of said probe (10), and said control circuit (40) being configured such that said indicator signal is formed from comparing said control signal to said measurement signal for agreement in time.

2. The sensor device as set forth in claim 1, **characterized in that** said electronic measuring circuit (20) is mounted on said probe (10), preferably forming a structural unit, more particularly a housing unit, therewith.

3. The sensor device as set forth in claim 1 or 2, **characterized in that** said electronic measuring circuit (20) and said control circuit (40) are so configured that said control signal, said measurement signal and a power supply for said electronic measuring circuit (20) are communicated via only two leads (7, 8) connected between said electronic measuring circuit (20) and said control circuit (40).

4. The sensor device as set forth in any of the claims 1 to 3, **characterized in that** said electronic measuring circuit (20) is configured such that said measurement signal is generated by said electronic measuring circuit (20) at a temporal interval following receipt of said at least one control signal.

5. The sensor device as set forth in any of the claims 1 to 4, **characterized in that** said electronic measuring circuit (20) comprises an encoder (22) generating reference values according to said received control signals, and a comparator (26) that compares said reference values with said signals from said probe (10) representing said distance (d) and which generates said measurement signal when said reference value produced by said encoder (22) matches the signal from said probe (10).

6. The sensor device as set forth in claim 5, **characterized in that** said encoder (22) comprises a binary counter (23) which generates a reference value corresponding to a count, more particularly a reference value increasing with incrementing of said count, more particularly via a connected D/A converter, more particularly a switchable resistance network (24), that said control circuit (40) comprises a clock generating said control signals as counting or clock signals for said counter (23), as well as generating a reset signal which after a string of counting or clock signals comprising a number of signals that corresponds to said count of said counter (23) representing a maximal reference value resets said counter (23) to an initial condition (0).

7. The sensor device as set forth in any of the claims 1 to 6, **characterized in that** said control circuit (40) comprises a means for monitoring the functionality of said electronic measuring circuit (20) including said probe (10), preferably comprising a current-measuring device to monitor current powering said electronic measuring circuit (20) including said probe (10).

8. The sensor device as set forth in any of the claims 1 to 7, **characterized in that** said probe (10) comprises an oscillator with a coil (11), the Q-factor of said oscillator (10) being variable by the spatial relationship between said coil (11) and said target surface (9).

## Revendications

1. Dispositif capteur pour la surveillance sans contact d'une position définie, en particulier d'une position finale d'une pièce fonctionnelle mécanique, en particulier d'une porte dans un avion, comportant
- un palpeur (10) fixé sur un avion et destiné à palper une distance (d) entre le palpeur (10) et une surface de mesure (9) sur une pièce fonctionnelle,
- un circuit électronique de mesure (20) connecté au palpeur (10) et réalisé de telle sorte qu'un signal de mesure correspondant à la distance (d) est généré en réponse à au moins un signal de commande, et
- un circuit de commande (40) qui est connecté au circuit électronique de mesure (20) via des lignes (7, 8), qui génère le signal de commande, qui reçoit le signal de mesure, et qui génère un signal indicateur pour indiquer la position finale constatée, **caractérisé en ce que** le circuit de commande (40) pour générer un groupe de signaux de commande et le circuit électronique de mesure (20) sont réalisés de telle sorte que lors de la réception de chaque signal de commande parmi le groupe de signaux de commande, une autre valeur comparative est générée qui est comparée avec un signal, dépendant de la distance (d), du palpeur (10) et lors d'une coïncidence d'une valeur comparative avec le signal du palpeur (10) le circuit électronique de mesure (20) génère le signal de mesure, et le circuit de commande (40) est réalisé de telle sorte que le signal indicateur est formé à partir d'une comparaison de la coïncidence temporelle du signal de commande avec le signal de mesure.

2. Dispositif capteur selon la revendication 1, **caractérisé en ce que** le circuit électronique de mesure (20) est agencé sur le palpeur (10), de préférence en formant un ensemble structurel avec celui-ci, en particulier un ensemble de boîtier.

3. Dispositif capteur selon l'une ou l'autre des revendications 1 et 2, **caractérisé en ce que** le circuit électronique de mesure (20) et le circuit de commande (40) sont réalisés de telle sorte que le signal de commande, le signal de mesure et une alimentation en courant électrique pour le circuit électronique de mesure (20) sont transmis seulement via deux lignes (7, 8) entre le circuit électronique de mesure (20) et le circuit de commande (40).

4. Dispositif capteur selon l'une des revendications 1 à 3, **caractérisé en ce que** le circuit électronique de mesure (20) est réalisé de telle sorte que le signal de mesure est généré par le circuit électronique de mesure (20) à un intervalle temporel après réception dudit au moins un signal de commande.

5. Dispositif capteur selon l'une des revendications 1 à 4, **caractérisé en ce que** le circuit électronique de mesure (20) comprend un système de codage (22) qui génère des valeurs comparatives en coïncidence avec des signaux de commande reçus, et un circuit comparateur (26) qui compare les valeurs comparatives avec des signaux du palpeur (10) représentant la distance (d), et qui génère le signal de mesure lorsque la valeur comparative générée coïncide avec le signal du palpeur (10).

6. Dispositif capteur selon la revendication 5, **caractérisé en ce que** le système de codage (22) comprend un compteur binaire (23) qui génère la valeur comparative correspondant à un contenu du compteur, en particulier une valeur comparative augmentant avec l'augmentation du contenu du compteur via un convertisseur numérique/analogique branché, en particulier via un réseau commutable de résistances (24), **en ce que** le circuit de commande (40) comprend une horloge qui génère les signaux de commande comme signaux de comptage ou d'horloge pour le compteur (23) ainsi qu'un signal de remise à zéro qui, après un groupe de signaux de comptage ou d'horloge, dont le nombre appartient au contenu du compteur (23) appartenant à une valeur comparative maximale, remet le compteur (23) dans un état initial (0).

7. Dispositif compteur selon l'une des revendications 1 à 6, **caractérisé en ce que** le système de commande (40) comprend un système de surveillance pour surveiller la capacité de fonctionnement du circuit électronique de mesure (20) avec le palpeur (10), qui comprend de préférence un système de mesure de courant électrique pour surveiller un courant électrique d'alimentation pour le circuit électronique de mesure (20) avec le palpeur (10).

8. Dispositif compteur selon l'une des revendications 1 à 7, **caractérisé en ce que** le palpeur (10) comprend un circuit oscillant avec une bobine (11), un paramètre du circuit oscillant (10) étant variable par relation dans l'espace entre la bobine (11) et la surface de mesure (9).
